# EUROPÄISCHE PATENTSCHRIFT

(11) **EP 2 903 112 B1**
(45) Veröffentlichungstag und Bekanntmachung des Hinweises auf die Patenterteilung: **12.04.2017**
(21) Anmeldenummer: 15000628.6
(22) Anmeldetag: 03.05.2011
(51) Int. Cl.: H02H 1/00, G01R 31/02, H02H 3/027

(54) **VERFAHREN ZUR ERKENNUNG VON STÖRLICHTBÖGEN UND SCHUTZSCHALTER**
METHOD FOR IDENTIFYING ARCING FAULTS AND CIRCUIT BREAKER
PROCÉDÉ DE RECONNAISSANCE D'ARCS ÉLECTRIQUES PARASITES ET COUPE-CIRCUIT

(30) Priorität: 23.02.2011 DE 102011012004
(43) Veröffentlichungstag der Anmeldung: 05.08.2015
(62) Teilanmeldung aus: 11720033.7
(73) Patentinhaber: Ellenberger & Poensgen GmbH, D-90518 Altdorf (DE)
(72) Erfinder: Miklis, Markus, DE - 90592 Pfeifferhütte (DE)
(74) Vertreter: FDST Patentanwälte

(56) Entgegenhaltungen:
- WO-A1-94/22031
- WO-A1-2008/049436
- GB-A- 2 348 751

## Beschreibung

Die Erfindung betrifft Verfahren zur Erkennung von Störlichtbögen innerhalb eines eine Netzfrequenz, einen elektrischen Strom und eine elektrische Spannung aufweisenden Stromkreises sowie einen danach arbeitenden Schutzschalter.

Innerhalb eines elektrischen Stromkreises können sogenannten Störlichtbögen auftreten. Störlichtbögen sind unerwünschte Ströme zwischen zumindest einem Element des Stromkreises und einem weiteren Element, wobei zwischen den beiden Elementen eine Potentialdifferenz existiert. Üblicherweise stehen die beiden Elemente nicht in direktem elektrischem Kontakt, sondern meist befindet sich zwischen diesen eine Isolierung. Ist die Isolierung defekt, indem diese beispielsweise aufgrund von Alterung porös geworden ist oder infolge mechanischen Einwirkens zumindest teilweise entfernt ist, so ist es möglich, dass zwischen den beiden Elementen ein weiterer Stoff eindringt und sich dort anlagert. Dieser Stoff kann flüssig, beispielsweise Wasser, oder gasförmig, insbesondere Luft, sein. Aufgrund der fehlenden Isolationswirkung ist es bei den innerhalb des Stromkreises auftretenden Strömen und/oder Spannungen möglich, dass ein elektrischer Überschlag, der Störlichtbogen, zwischen den beiden Elementen auftritt.

Es werden drei verschiedene Typen von Störlichtbögen, auch Arc genannt, unterschieden. Bei dem sogenannten Wet-Arc ist der eindringende Stoff eine Flüssigkeit, meist Wasser, die eine hohe elektrische Leitfähigkeit aufweist. Das weitere Element ist meist elektrisch mit Masse verbunden oder geerdet und nicht zwangsläufig ein Bestandteil des Stromkreises. Aufgrund der hohen elektrischen Leitfähigkeit und somit aufgrund des geringen elektrischen Widerstandes der Flüssigkeit können zwischen den beiden Elementen vergleichsweise hohe Ströme auftreten, was zu einer Beeinträchtigung etwaiger Verbraucher des elektrischen Stromkreises führen kann.

Bei einem sogenannten Parallel-Arc ist der eindringende Stoff ein Gas, insbesondere Luft. Das weitere Element ist meist elektrisch mit Masse verbunden oder geerdet und nicht zwangsläufig ein Bestandteil des Stromkreises. Aufgrund des elektrischen Feldes zwischen den beiden Elementen wird das Gas ionisiert und es kann ein elektrischer Strom zwischen den beiden Elementen fließen. Schon bei Potentialdifferenzen von ca. 30 Volt ist ein derartiger Überschlag möglich. Aufgrund der vergleichsweise schlechten elektrischen Leitfähigkeit des ionisierten Gases ist der elektrische Strom zwischen den beiden Elementen nicht konstant, sondern vielmehr hochfrequent, was zu einer hohen thermischen Aufladung der beiden Elemente, des Stoffes und/oder deren jeweiliger Umgebung führt. Die hierbei auftretenden Temperaturen erreichen bis zu einige tausend Grad, so dass eine weitere Beschädigung der Isolation, der Elemente und/oder der jeweiligen Umgebung nicht ausgeschlossen ist.

Insbesondere bei Flugzeugen ist diese Gefahr besonders groß, da üblicherweise verlegte Kabel zu Kabelbäumen zusammen gefasst werden. Falls das erste Element eines dieser Kabel ist, kann ein auftretender Störbogen den gesamten Kabelbaum schädigen und somit die Betriebssicherheit des Flugzeuges gefährden. Weiterhin ist es möglich, dass den Kabelbaum umgebende Elemente oder der Kabelbaum selbst in Brand geraten.

Ein weiterer Störlichtbogen-Typ ist der Seriell-Arc. Bei diesem ist das weitere Element das erste Element selbst, welches meist ein Kabel ist. Der Überschlag erfolgt entlang des Kabels, wobei der eingedrungene Stoff meist Luft ist, die durch eine porös gewordenen Isolierung in elektrischem Kontakt zu dem Kabel steht. Der Mechanismus der zu diesem Störlichtbogen führt ist vergleichbar mit dem Parallel-Arc und ebenso auch dessen Auswirkungen.

Aus der WO 94/22031 A1 sind zwei Verfahren zum Erkennen von Störlichtbögen bekannt. Das erste der beiden Verfahren sieht vor, den elektrischen Strom oder die elektrische Spannung innerhalb eines Wechselstromkreises auf Störsignale zu überwachen, deren Länge im Wesentlichen einer halben Netzfrequenz entspricht.

Hierbei werden die zwischen zwei aufeinanderfolgenden Störsignalen gebildeten Zeiträume auf deren Länge, deren Beginn oder deren Ende hin analysiert. Sofern zwei im Abstand einer Netzfrequenz aufeinanderfolgende Zeiträume vorliegen, wird ein Zähler erhöht. Falls eine bestimmte Anzahl von regelmäßigen störsignalfreien Zeiträumen vorliegt ist ein Störlichtbogen erkannt. Anstatt dessen können nach Registrierung der bestimmten Anzahl von Störlichtbogen weiterhin die Zeiträume gezählt werden. Falls ein Zeitraum unregelmäßig ist, wird der Zähler um einen vorgegebenen Wert reduziert. Falls der Zähler eine bestimmte zweite Anzahl erreicht hat, wird ein Störlichtbogen gemeldet.

Bei dem zweiten Verfahren werden Störsignale auf deren Unregelmäßigkeiten hin überprüft. Falls sich aufeinanderfolgende Störsignale in deren Position relativ zur Netzfrequenz und deren Länge unterscheiden, ist ein Störlichtbögen erkannt. Zusätzlich wird der Anstieg des jeweiligen Störsignals analysiert, da der Erfinder erkannt hat, dass Störsignale, die von Störlichtbögen hervorgerufen werden, einen zeitlich steileren Anstieg aufweisen als etwaige Störsignale, die von Halbleiterschaltelementen innerhalb des Stromkreises bedingt sind.

Die vorgestellten Verfahren werden von einem Schutzschalter, einem Überwachungselement und einem tragbaren Analysegerät ausgeführt.

In der WO 2008/049436 A1 ist ein Schutzschalter zur Überwachung von losen Verbindungen in einem Stromkreis bekannt. Der Schutzschalter löst aus, wenn in dem zu überwachenden Stromkreis ein hochfrequentes Signal detektiert wird. In einer Weiterbildung wird der Stromkreis mittels des Schutzschalters unterbrochen, wenn eine bestimmte Anzahl von derartigen Signalen innerhalb eines vorgegebenen Zeitfensters ermittelt wurde.

Aus der GB 2 348 751 A ist ein Verfahren zur Überwachung von Störlichtbögen innerhalb eines in einem Flugzeug realisierten Stromkreises bekannt. Hierbei wird der Anstieg von Störsignalen registriert und anhand dessen ein Störlichtbögen erkannt. Dabei wird die Anzahl von derartigen Störsignalen gezählt, die innerhalb eines zur halben Netzfrequenz korrespondierenden Zeitfensters auftreten.

Der Erfindung liegt die Aufgabe zugrunde, sowohl ein besonders geeignetes Verfahren zur Erkennung von Störlichtbögen innerhalb eines eine Netzfrequenz, einen elektrischen Strom und eine elektrische Spannung aufweisenden Stromkreises als auch einen besonderes geeigneten Schutzschalter anzugeben.

Die das Verfahren betreffende Aufgabe wird erfindungsgemäß gelöst durch die Merkmale des Anspruchs 1. Eine vorteilhafte Weiterbildung ist Gegenstand der hierauf rückbezogenen Unteransprüche.

Im Folgenden wird unter einem Störsignal eine Abweichung eines Istwertes eines elektrischen Stromes von einem zugehörigen Sollwert verstanden. Die Abweichung weist eine Zeitdauer und während dieser eine bestimmte Frequenz auf, wobei die Abweichung auch eine Anzahl von Frequenzen oder ein Frequenzband während dieser Zeitspanne aufweisen kann. Nachfolgend wird davon ausgegangen, dass ein Störsignal lediglich eine Frequenz umfasst, wobei jedoch das Störsignal auch mehrere Frequenzen umfassen kann. Befinden sich die Frequenz der Abweichungen unterhalb einer NF1-Frequenz, wobei währenddessen der elektrische Strom oberhalb einer NF1-Grenzschwelle liegt, so wird dieses Störsignal als NF1-Signal bezeichnet. Unter einem NF2-Signal wird ein Störsignal verstanden, dessen Frequenz kleiner als eine NF2-Frequenz ist, während zeitgleich die Stromstärke größer als eine NF2-Grenzschwelle ist. Als Länge des NF1- Signals und als Länge des NF2-Signals wird die Zeitdauer bezeichnet, die das Störsignal mit den jeweiligen obigen Parametern andauert.

Als ein HF2-Signal wird eine Anzahl von Störsignalen, die eine Frequenz unterhalb einer HF2-Frequenz aufweisen, bezeichnet. Hierbei ist der zeitliche Abstand zweier aufeinanderfolgender Störsignale kleiner als eine HF2-Zeit, und die Anzahl der Störsignale ist größer als eine HF2-Anzahl. Tritt ein weiteres Störsignal mit einer Frequenz unterhalb der HF2-Frequenz innerhalb einer Zeitspanne, die kleiner als die HF2-Zeit ist, nach dem letzten Störsignal eines HF2-Signals auf, so wird das weitere Störsignal zu dem HF2-Signal gezählt und die Länge des HF2-Signals entsprechend verlängert. Dies führt unter anderem dazu, dass der zeitliche Abstand zweier aufeinanderfolgender HF2-Signale größer als die HF2-Zeit ist.

Folgen eine Anzahl von Zeiträumen, innerhalb derer mindestens jeweils ein HF2-Signal liegt, direkt aufeinander, so wird dies als eine Anhäufung bezeichnet. Die Länge jeder der Zeiträume beträgt hierbei einer Anhäufungs-Länge. Die Anzahl der Anhäufungen ist größer oder gleich einer Anhäufungs-Anzahl. Tritt in einem weiteren Zeitraum mit einer zeitlichen Länge, die der Anhäufungs-Länge entspricht, nach dem letzten ein HF2-Signal enthaltenden Zeitraum einer Anhäufung ein weiteres HF2-Signal auf, so wird der das weitere HF2-Signal enthaltende Zeitraum zu der Anhäufung gezählt und die Länge der Anhäufung entsprechend verlängert.

Es ist insbesondere möglich, dass ein Störsignal zu einer Anzahl der oben genannten Signale und/oder der Anhäufung beiträgt. Weiterhin wird im Folgenden davon ausgegangen, dass, falls ein Signal einen Zeitraum, eine Zeitspanne, eine zeitliche Phase oder eine zeitliche Periode startet, oder der Zeitraum, die Zeitspanne, die zeitliche Phase oder die zeitliche Periode mittels des Signals gestartet wird, das Signal zu dem Zeitraum, der Zeitspanne, der zeitlichen Phase oder der zeitlichen Periode gezählt wird, also innerhalb des Zeitraums, der Zeitspanne, der zeitlichen Phase oder der zeitlichen Periode liegt.

Ein Verfahren, das nicht der vorliegenden Erfindung entspricht, nutzt einen nachfolgend als WET1-Anhäufungszähler bezeichneten Zähler. Bei dem Start des Verfahrens wird der WET1-Anhäufungszähler auf null (0) gesetzt. Jedes Mal, wenn der WET1-Anhäufungszähler null (0) beträgt, wird, falls eine Anhäufung identifiziert wird, der WET1-Anhäufungszähler um eins (1) erhöht. Mit anderen Worten wird der Zählerstand des WET1-Anhäufungszählers um eins (1) erhöht, sobald eine Anhäufung innerhalb des elektrischen Stroms des Stromkreises erkannt wird. Mit jeder weiteren identifizierten Anhäufung wird der Zählerstand des WET1-Anhäufungszählers um eins (1) erhöht, solange der zeitliche Abstand zweier aufeinanderfolgender Anhäufungen größer als eine erste Anhäufungs-Zeit und kleiner als eine zweite Anhäufungs-Zeit ist. Ist dies nicht der Fall, so wird der WET1-Anhäufungszähler auf null (0) zurückgesetzt.

Erreicht der Zählerstand des WET1-Anhäufungszählers einen Anhäufungswert, so wird eine Warteperiode gestartet und insbesondere während der Warteperiode der Zählerstand des WET1-Anhäufungszählers nicht weiter verändert. Falls während der Warteperiode zwei aufeinanderfolgende Anhäufungen einen zeitlichen Abstand aufweisen, der kleiner als eine dritte Anhäufungs-Zeit ist, so wird die Warteperiode abgebrochen und der WET1-Anhäufungszähler auf null (0) gesetzt. Ebenfalls führt mindestens ein NF1-Signal, vorzugsweise ein, zwei, oder drei NF1-Signale, zu einem Abbruch der Warteperiode und einem Zurücksetzten des WET1-Anhäufungszählers auf null (0). Endet die Warteperiode regulär, wird also die Warteperiode nicht abgebrochen, so wird nach Ablauf der Warteperiode ein Störlichtbogen gemeldet.

Falls ein NF2-Signal, das länger als eine NF2-Grenzlänge andauert, innerhalb des elektrischen Stroms gemessen wird, wird geeigneterweise der WET1-Anhäufungszähler auf null (0) gesetzt und für einen Parallelzeitraum auf null (0) belassen. Der WET1-Anhäufungszähler wird also während des Parallelzeitraums nicht um eins (1) erhöht, falls währenddessen eine Anhäufung identifiziert wird. In dem Fall, dass ein derartiges NF2-Signal während der Warteperiode gemessen wird, wird diese abgebrochen, der WET1-Anhäufungszähler auf null (0) gesetzt und ebenfalls für den Parallelzeitraum auf null (0) belassen.

Der Parallelzeitraum wird jedes Mal dann beendet, falls während des Parallelzeitraums ein NF2-Signal gemessen wird, dessen Länge kürzer als die NF2-Grenzlänge ist. Ebenfalls wird jedes Mal der Parallelzeitraum abgebrochen, wenn die elektrische Spannung für eine erste Abbruch-Zeitspanne kleiner einer Abbruch-Spannung war, oder wenn für einen Zeitraum, der die Länge einer zweiten Abbruch-Zeitspanne aufweist, kein NF2-Signal gemessen wurde.

Dahingegen wird ein Störlichtbogen gemeldet, falls eine Anzahl von HF2-Signalen innerhalb des Parallelzeitraums gemessen wurde, wobei der zeitliche Abstand jeweils zweier aufeinanderfolgender HF2-Signale größer oder gleich einer ersten Störlichtbogen-Zeitspanne ist. Einer der Abstände zwischen zweien der HF2-Signale ist hierbei größer oder gleich einer zweiten Störlichtbogen-Zeitspanne, wobei diese größer oder gleich der ersten Störlichtbogen-Zeitspanne ist.

Die Anzahl der HF2-Signale, die zu einem gemeldeten Störlichtbogen führen, hängt von etwaigen NF2-Signalen innerhalb einer dritten Störlichtbogen-Zeitspanne ab. Die dritte Störlichtbogen-Zeitspanne bezeichnet den zeitlich ersten Abschnitt des Parallelzeitraums.

Wird innerhalb der dritten Störlichtbogen-Zeitspanne eine Anzahl von NF2-Signalen gemessen, die zwischen einschließlich einer zweiten Störlichtbogen-Anzahl und einer dritten Störlichtbogen-Anzahl liegt, so ist die Anzahl der zu der Meldung führenden HF2-Signale größer oder gleich einer ersten Störlichtbogen-Anzahl. Insbesondere ist die dritte Störlichtbogen-Anzahl größer als die zweite Störlichtbogen-Anzahl. Falls innerhalb der dritten Störlichtbogen-Zeitspanne eine Anzahl von NF2-Signale gemessen wurde, die größer als die dritte Störlichtbogen-Anzahl ist, so wird erst nach dem Messen von einer Anzahl, die größer oder gleich einer vierten Störlichtbogen-Anzahl ist, von HF2-Signalen der Störlichtbogen gemeldet.

Ein weiteres Verfahren, das nicht der vorliegenden Erfindung entspricht, nutzt einen nachfolgend als WET2-Anhäufungszähler bezeichneten Zähler und einen NF1-Zähler. Mit dem Start des Verfahrens werden der WET2-Anhäufungszähler und der NF1-Zähler jeweils auf null (0) gesetzt. Wenn der WET2-Anhäufungszähler null (0) beträgt und eine Anhäufung identifiziert wird, wird der WET2-Anhäufungszähler um eins (1) erhöht. Mit anderen Worten wird der Zählerstand des WET2-Anhäufungszählers um eins (1) erhöht, sobald eine Anhäufung innerhalb des elektrischen Stroms des Stromkreises erkannt wird. Mit jeder weiteren identifizierten Anhäufung wird der Zählerstand des WET2-Anhäufungszählers um eins (1) erhöht, solange der zeitliche Abstand zweier aufeinanderfolgender Anhäufungen kleiner der dritten Anhäufungs-Zeit ist. Wird nach einer der Anhäufungen für einen Zeitraum, der größer als eine dritte Anhäufungs-Zeit ist, keine Anhäufung gemessen, so wird entweder der WET2-Anhäufungszähler auf null (0) gesetzt, falls der Zählerstand des WET2-Anhäufungszähler kleiner oder gleich einem ersten WET2-Grenzwertes ist, oder es wird eine NF-Periode gestartet, falls der Zählerstand des WET2-Anhäufungszähler größer als der erste WET2-Grenzwert ist. Insbesondere wird der Zählerstand des WET2- Anhäufungszählers innerhalb der NF-Periode nicht weiter erhöht.

Jedes NF1-Signal, das innerhalb der NF-Periode gemessen wird, führt zu einer Erhöhung des NF1-Zählers um eins (1). Überschreitet der Zählerstand des NF1-Zählers einen WET2-Grenzwert, so wird ein Störlichtbogen gemeldet. Ist nach Ablauf der NF-Periode der Zählerstand kleiner als der WET2-Grenzwert, werden der WET2-Anhäufungszähler und der NF1-Zähler jeweils auf null (0) gesetzt.

In einem Beispiel wird die elektrische Spannung überwacht. Ist für einen Zeitraum, der länger als eine zweite SPG-Zeitspanne ist, die elektrische Spannung kleiner als eine SPG-Spannung, so werden der WET2-Anhäufungszähler und der NF1-Zähler auf null (0) gesetzt. Die SPG-Spannung ist hierbei vorteilhafterweise konstant, kann jedoch ebenso ein variabler Schwellwert unter- oder oberhalb einer Sollspannung sein. Die beiden Zähler werden ebenfalls zurückgesetzt, falls sich die Längen zweier aufeinanderfolgender Hochzeitspannen um mehr als eine dritte SPG-Zeitspanne unterscheiden. Als Hochzeitspannen wird die Zeitspanne bezeichnet, innerhalb derer die Spannung größer als die SPG-Spannung ist. Gegebenenfalls wird in beiden Fällen die NF-Periode abgebrochen, falls diese bereits begonnen hat. Sollten die beiden Zähler aufgrund der elektrischen Spannung auf null (0) gesetzt werden, so werden anschließend der WET2-Anhäufungszähler und der NF1-Zähler für eine erste SPG-Zeitspanne nicht verändert.

Zweckmäßigerweise wird der WET2-Anhäufungszähler und der NF1-Zähler auf null (0) zurückgesetzt und während des sich daran anschließenden Parallelzeitraums nicht verändert, falls ein NF2-Signal gemessen wird, dessen Länge größer als die NF2-Grenzlänge ist. In Kombination dazu wird die NF-Periode abgebrochen, falls diese bereits begonnen hat.

Ein Störlichtbogen wird gemeldet, falls innerhalb des Parallelzeitraums zwischen allen aufeinanderfolgenden HF2-Signalen der zeitliche Abstand größer oder gleich der ersten Störlichtbogen-Zeitspanne ist, wobei einer der Abstände größer oder gleich der zweiten Störlichtbogen-Zeitspanne ist. Hierbei ist die Anzahl der HF2-Signale, die zu der Meldung führt, abhängig von etwaigen NF2-Signalen, die innerhalb der dritten Störlichtbogen-Zeitspanne des Parallelzeitraums in dem elektrischen Strom gemessen werden. Ist die Anzahl der gemessenen NF2-Signale größer oder gleich der zweiten Störlichtbogen-Anzahl und kleiner oder gleich der dritten Störlichtbogen-Anzahl, so wird der Störlichtbogen gemeldet, falls eine Anzahl von HF2-Signalen innerhalb des Parallelzeitraums gemessen wurde, die mindestens der ersten Störlichtbogen-Anzahl entspricht. Ist die Anzahl der gemessenen NF2-Signale größer als die dritten Störlichtbogen-Anzahl, so wird erst nachdem eine Anzahl, die größer oder gleich der vierten Störlichtbogen-Anzahl ist, von HF2-Signalen der Störlichtbogen gemeldet.

Der Parallelzeitraum wird beendet und kein Störlichtbogen gemeldet, falls während des Parallelzeitraums die Länge eines NF2-Signals kürzer als die NF2-Grenzlänge ist, oder für einen Zeitraum, dessen Länge zumindest der Länge der zweiten Abbruch-Zeitspanne entspricht, kein NF2-Signal gemessen wurde. Sollte innerhalb des Parallelzeitraums für die erste Abbruch-Zeitspanne die elektrische Spannung kleiner als die Abbruch-Spannung sein, so wird der Parallelzeitraum beendet und auch kein Störlichtbogen gemeldet.

Das Verfahren gemäß der vorliegenden Erfindung sieht vor, einen Seriellzeitraum zu nutzen. Falls außerhalb des Seriellzeitraums in dem elektrischen Strom ein HF2-Signal registriert wird, so wird der Seriellzeitraum gestartet. In dem Seriellzeitraum werden die gegebenenfalls in dem elektrischen Strom vorhandenen NF1-Signale gezählt. Hierbei werden lediglich diejenigen NF1-Signale gezählt, deren zeitlicher Abstand zueinander zwischen einer fünften Abbruch-Zeitspanne und einer sechsten Abbruch-Zeitspanne liegt, wobei die fünfte Abbruch-Zeitspanne kleiner als die sechste Abbruch-Zeitspanne ist. In einer ersten Messphase des Seriellzeitraums, die mit dem Start des Seriellzeitraums beginnt, werden die gegebenenfalls in dem elektrischen Strom vorhandenen HF2-Signale gezählt. Hierbei werden lediglich diejenigen HF2-Signale gezählt, deren zeitlicher Abstand zu dem jeweiligen vorhergehenden HF2-Siganl zwischen einer vierten Abbruch-Zeitspanne und einer dritten Abbruch-Zeitspanne liegt, wobei die vierte Abbruch-Zeitspanne kleiner als die dritte Abbruch-Zeitspanne ist. Sollte einer der Abstände größer als die dritte Abbruch-Zeitspanne sein, so wird sowohl die erste Messphase abgebrochen als auch der Seriellzeitraum beendet.

Ist die Anzahl der innerhalb der ersten Messphase gezählten HF2-Signale gleich einer ersten Seriellen-Anzahl, wobei das den Seriellzeitraum startende HF2-Signal zu der Anzahl der gezählten HF2-Signale hinzu gezählt wird, so wird eine Halteperiode gestartet. Insbesondere wird die erste Messphase beendet, falls die Anzahl der gemessenen HF2-Signale gleich der ersten Seriellen-Anzahl ist, und geeigneterweise darauf im Anschluss die Halteperiode gestartet. Hierbei umfasst insbesondere die erste Messphase dasjenige zeitlich letzte HF2-Signal, mittels dessen die Anzahl der gemessenen HF2-Signale der ersten Seriellen-Anzahl entspricht, da das zeitlich letzte HF2-Signal die erste Messphase beendet und nicht die Halteperiode startet.

Nach Ablauf der Halteperiode werden in einer sich vorzugsweise direkt anschließenden zweiten Messphase die gegebenenfalls in dem elektrischen Strom vorhandenen HF2-Signale gezählt, deren zeitlicher Abstand zu dem vorhergehenden HF2-Signal zwischen der vierten Abbruch-Zeitspanne und der dritten Abbruch-Zeitspanne liegt. Sollte einer der Abstände größer als die dritte Abbruch-Zeitspanne sein, so wird sowohl die zweite Messphase abgebrochen als auch der Seriellzeitraum beendet. Insbesondere wird das zeitlich erste HF2-Signal der zweiten Messphase gezählt, wenn das zeitlich nachfolgende HF2-Signal zu dem ersten einen zeitlichen Abstand aufweist, der zwischen der vierten Abbruch-Zeitspanne und der dritten Abbruch-Zeitspanne liegt.

Ist die Anzahl der innerhalb der zweiten Messphase gezählten HF2-Signale gleich einer zweiten Seriellen-Anzahl, wird die Anzahl der NF1-Signale überprüft. Insbesondere wird die zweite Messphase beendet, falls die Anzahl der gemessenen HF2-Signale gleich der zweiten Seriellen-Anzahl ist, und geeigneterweise wird der Seriellzeitraum ebenfalls beendet. Falls die Anzahl der innerhalb des Seriellzeitraums gezählten NF1-Signale größer als eine dritten Seriellen-Anzahl ist, oder falls die Anzahl der innerhalb des Seriellzeitraums gezählten NF1-Signale gleich der dritten Seriellen-Anzahl ist, und für zumindest die fünfte Abbruch-Zeitspanne nach dem letzten gezählten NF1-Signal kein weiteres NF1-Signal in dem elektrischen Strom registriert wurde, wird ein Störlichtbogen gemeldet.

In einer zweckmäßigen Ausführungsform der Erfindung wird die elektrische Spannung überwacht. Ist für einen Zeitraum, der länger als die zweite SPG-Zeitspanne ist, die elektrische Spannung kleiner als die SPG-Spannung, so wird der Seriellzeitraum beendet, falls dieser bereits begonnen hat, und für die ersten SPG-Zeitspanne nicht gestartet. Mit andern Worten führt ein innerhalb der SPG-Zeitspanne gemessenes HF2-Signal nicht zu einem Starten des Seriellzeitraums. Falls sich die Längen zweier aufeinanderfolgender Hochzeitspannen um mehr als die dritte SPG-Zeitspanne unterscheiden, so wird der Seriellzeitraum beendet, falls dieser bereits begonnen hat, und für die ersten SPG-Zeitspanne nicht gestartet.

Vorteilhafterweise wird der Seriellzeitraum beendet, falls dieser bereits begonnen hat, und auf jeden Fall für den Parallelzeitraum nicht gestartet, falls ein NF2-Signal gemessen wird, das länger als die NF2-Grenzlänge andauert. Falls während des Parallelzeitraums für einen Zeitraum, der die Länge der zweiten Abbruch-Zeitspanne aufweist, kein NF2-Signal gemessen wurde, oder falls die Länge eines gemessen NF2-Signal kleiner als die NF2-Grenzlänge ist, oder falls für die erste Abbruch-Zeitspanne die elektrische Spannung kleiner als die Abbruch-Spannung war, so wird der Parallelzeitraum beendet.

Falls innerhalb des zeitlich ersten Abschnitts des Parallelzeitraums, der die Länge der dritten Störlichtbogen-Zeitspanne aufweist, eine Anzahl von NF2-Signalen, wobei das den Parallelzeitraum startenden NF2-Signal ebenfalls dazu gezählt wird, die zwischen einschließlich der zweiten Störlichtbogen-Anzahl und der dritten Störlichtbogen-Anzahl liegt, und eine Anzahl von HF2-Signalen gezählt werden, die größer oder gleich der ersten Störlichtbogen-Anzahl ist, so wird ein Störlichtbogen gemeldet. Werden in dem ersten Abschnitt mehr NF2-Signale gemessen, wobei hier ebenso das den Parallelzeitraum startenden NF2-Signal dazu gezählt wird, so wird erst nachdem in dem Parallelzeitraums mindestens eine Anzahl von HF2-Signalen gezählt wurde, die größer oder gleich der vierten Störlichtbogen-Anzahl ist, ein Störlichtbogen gemeldet. In beiden Fällen werden lediglich die HF2-Signale innerhalb des Parallelzeitraums gezählt, deren zeitlicher Abstand zu dem jeweiligen direkt vorhergehenden HF2-Signal größer als der ersten Störlichtbogen-Zeitspanne ist, und der Störlichtbogen wird erst gemeldet, wenn einer der Abstände größer oder gleich der zweiten Störlichtbogen-Zeitspanne ist.

Falls ein NF2-Signal gemessen wird, das länger als die NF2-Grenzlänge andauert, so wird der Parallelzeitraum gestartet. Mit dem Parallelzeitraum beginnt ebenfalls jedes Mal die dritte Störlichtbigen-Zeitspanne. Der Parallelzeitraum wird immer dann beendet, falls entweder ein NF2-Signal gemessen wird, dessen Länge kürzer als die NF2-Grenzlänge ist, oder falls die elektrische Spannung des Stromkreises für die erste Abbruch-Zeitspanne kleiner als die Abbruch-Spannung war, oder falls für einen Zeitraum, der die Länge der zweiten Abbruch-Zeitspanne aufweist, kein NF2-Signal gemessen wurde.

Falls innerhalb der dritten Störlichtbogen-Zeitspanne eine Anzahl NF2-Signale, die zwischen einschließlich einer zweiten Störlichtbogen-Anzahl und einer dritten Störlichtbogen-Anzahl liegt, und eine Anzahl HF2-Signale, die größer oder gleich einer ersten Störlichtbogen-Anzahl ist, gemessen werden, so wird ein Störlichtbogen gemeldet. Falls die Anzahl der innerhalb der dritten Störlichtbogen-Zeitspanne gemessen NF2-Signale größer als die dritte Störlichtbogen-Anzahl ist, so wird ein Störlichtbogen gemeldet, wenn die Anzahl der während des Parallelzeitraums registrierten HF2-Signale die vierte Störlichtbogen-Anzahl übersteigt. Geeigneterweise ist die dritte Störlichtbogen-Anzahl größer als die zweite Störlichtbogen-Anzahl.

Der Störlichtbogen wird in beiden Fällen jedoch nur dann gemeldet, wenn der zeitliche Abstand jeweils zweier direkt aufeinanderfolgender HF2-Signale innerhalb des Parallelzeitraums größer oder gleich der ersten Störlichtbogen-Zeitspanne und einer der Abstände größer oder gleich der zweiten Störlichtbogen-Zeitspanne ist.

Geeigneterweise läuft zumindest eine Anzahl der beschriebenen Verfahren parallel zueinander ab, soweit sie sich nicht gegenseitig ausschließen.

Die den Schutzschalter betreffende Aufgabe wird erfindungsgemäß gelöst durch die Merkmale des Anspruchs 4. Vorteilhafte Weiterbildungen und Ausgestaltungen sind Gegenstand der hierauf bezogenen Unteransprüche.

Mittels des Schutzschalters wird ein elektrischer Stromkreis überwacht, der eine elektrische Spannung, einen elektrischen Strom und eine Netzfrequenz aufweist. Der Schutzschalter ist dazu vorgesehen und eingerichtet zumindest eines der oben beschriebenen Verfahren durchzuführen. Insbesondere weist der Schutzschalter eine Überwachungseinheit für die elektrische Spannung und eine Überwachungseinheit für den elektrischen Strom auf, so dass NF1-Signale, NF2-Signale und/oder HF2-Signale identifiziert werden können. Zweckmäßigerweise sind die Überwachungseinheiten derart ausgestaltet, dass die Signale direkt aus den jeweiligen Messgrößen ermittelt werden können, also die Messgrößen beispielsweise nicht zunächst in den Frequenzraum transferiert und dort analysiert werden müssen.

Geeigneterweise weist der Schutzschalter eine Unterbrechungseinheit auf. Die Unterbrechungseinheit unterbricht den Stromkreis, sobald ein Störlichtbogen gemeldet ist. Auf diese Weise wird der Störlichtbogen beendet, so dass ein unkontrolliertes Entladen einer etwaigen Batterie beendet oder ein thermisches Aufheizen der Komponenten oder der Umgebung des Stromkreises verhindert wird.

Die beschriebenen Verfahren und der Schutzschalter eignen sich insbesondere für einen Stromkreis mit einer Netzfrequenz von 400Hz, wobei auch ein Einsatz bei einer Netzfrequenz zwischen 300Hz und 1kHz vorstellbar ist. Ebenso ist auch eine Anwendung in einem eine kleinere Netzfrequenz aufweisenden Stromkreis bis hin zu einer Anwendung in einem Stromkreis, innerhalb dessen ein Gleichstrom fließt, denkbar. Vorteilhafterweise beträgt die elektrische Spannung des Stromkreises 115V oder zwischen 220V und 230V. Insbesondere wird zumindest eines der Verfahren oder der Schutzschalter innerhalb eines Stromkreises eines Flugzeuges angewandt bzw. kommt dort zum Einsatz.

Nachfolgend wird ein Ausführungsbeispiel der Erfindung anhand einer Zeichnung näher erläutert. Darin zeigen:
- Fig. 1: schematisch einen elektrischen Stromkreis mit einem Schutzschalter,
- Fig. 2: eine Anzahl von NF1- oder NF2-Signalen,
- Fig. 3: eine Anzahl von HF2-Signalen,
- Fig. 4: eine Anzahl von Anhäufungen,
- Fig. 5: ein erstes Verfahren zur Erkennung eines Störlichtbogens,
- Fig. 6: ein zweites Verfahren zur Erkennung eines Störlichtbogens,
- Fig. 7: ein drittes Verfahren zur Erkennung eines Störlichtbogens,
- Fig. 8: ein viertes Verfahren zur Erkennung eines Störlichtbogens, und
- Fig. 9: den zeitlichen Verlauf einer elektrischen Spannung.

Einander entsprechende Teile sind in allen Figuren mit den gleichen Bezugszeichen versehen.

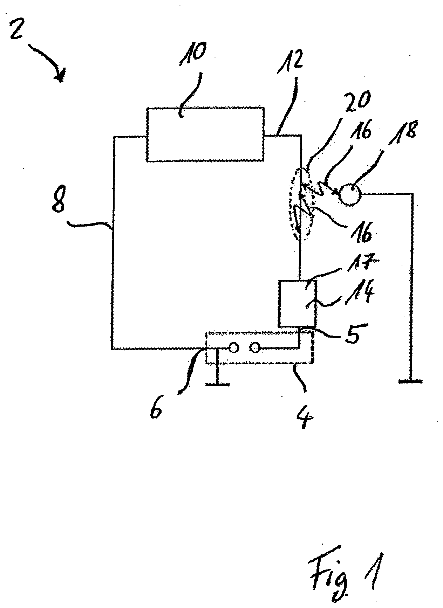

In Fig. 1 ist ein elektrischer Stromkreis 2 dargestellt. Der elektrische Stromkreis 2 umfasst eine elektrische Stromquelle 4 mit zwei Anschlüssen 5, 6, wobei einer der Anschlüsse 6 elektrisch mit Masse verbunden ist. Dieser Anschluss 6 ist über eine elektrische Leitung 8 mit einem Verbraucher 10 elektrisch verbunden. Der Verbraucher 10 ist beispielsweise ein elektrischer Stellmotor, eine Lampe, oder ein Sensor. Mit dem Verbraucher 10 ist über eine weitere elektrische Leitung 12 ein Schutzschalter 14 elektrisch verbunden, wobei der Schutzschalter 14 mit einem der Anschlüsse 5 der Stromquelle 4 verbunden ist. Der Schutzschalter 14 ist darauf ausgelegt, Störlichtbögen 16 innerhalb des elektrischen Stromkreises 2 zu erkennen und nach dem Erkennen den elektrischen Stromkreis 2 mittels einer Unterbrechungseinheit 17 zu unterbrechen. Der Störlichtbogen 16 tritt beispielsweise zwischen der elektrischen Leitung 12 und einem weiteren mit Masse verbundenen Element 18 auf, wobei beispielsweise eine Isolierung der elektrischen Leitung 12 in einem Bereich 20 in der Nähe des mit Masse verbundenen Elements 18 beschädigt ist. Zwischen dem Element 18 und der elektrischen Leitung befindet sich beispielsweise entweder Luft oder eine elektrisch leitende Flüssigkeit, wie insbesondere Salzwasser. Der Störlichtbogen 16 kann auch entlang der elektrischen Leitung 12 auftreten.

Die Stromquelle 4 liefert einen elektrischen Strom 22, der beispielsweise ein sinusförmig verlaufender Wechselstrom ist und eine Nennstromstärke aufweist. Die mittels der Stromquelle 4 erzeugt elektrische Spannung 24 weist einen ähnlichen Verlauf auf, wobei deren Nennspannungswert beispielsweise 115 Volt ist. Die Frequenz des Stromes 22 und die der Spannung sind jeweils gleich einer Netzfrequenz 26, die insbesondere 400 Hz beträgt. Der Stromkreis 2 ist vorzugsweise in einem Flugzeug realisiert. Zweckdienlicherweise liegt der Anschluss 6 auf dem gleichen elektrischen Potential wie die Flugzeugaußenhaut. Ebenso denkbar ist, dass falls der Stromkreis 2 nicht in einem Flugzeug realisiert ist, der Anschluss 6 und das Element 18 geerdet sind.

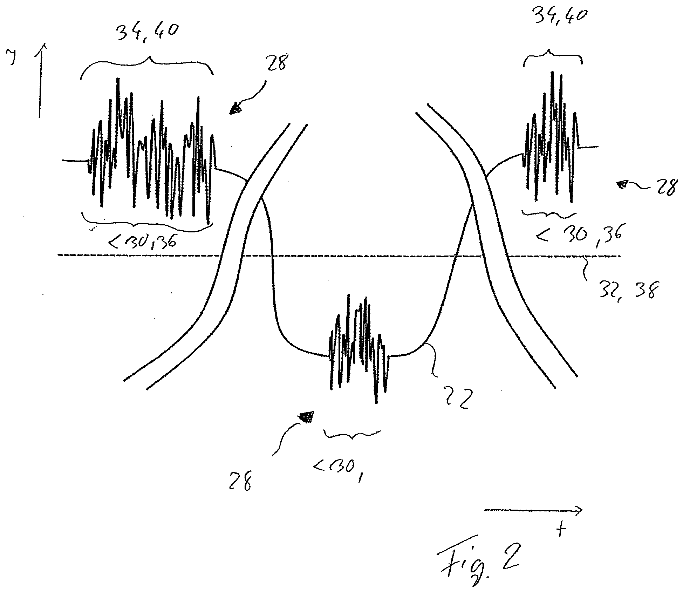

Fig. 2 zeigt eine Anzahl von Störsignalen 28 innerhalb des zeitlichen Verlaufs des elektrischen Stroms 22. Der Verlauf des elektrischen Stroms 22 ist hierbei beispielsweise nicht sinusförmig, sondern vielmehr, insbesondere hinsichtlich einer vergleichsweise einfachen Erläuterbarkeit, rechteckförmig. Dies schränkt jedoch die Erfindung in keinster Weise ein.

Die Frequenz jedes der Signale 28 liegt unterhalb einer NF1-Frequenz 30, die insbesondere 30kHz beträgt. Der elektrische Strom 22 des ersten der Störsignale 28 liegt oberhalb einer NF1-Grenzschwelle 32, welche beispielsweise ein Drittel des Nennstroms beträgt. Dieses Störsignal 28 wird als ein NF1-Signal 34 bezeichnet. Ebenso erfüllt das dritte der Störsingale 28 die beiden Kriterien eines NF1-Signals 34, wonach die Frequenz des Störsignals 28 kleiner als die NF1-Frequenz 30 ist, und wonach der elektrische Strom 22 des Störsignals 28 größer als die NF1-Grenzschwelle 32 ist. Hierbei ist das erste NF1-Signal 34 länger als das zweite NF1-Signal 34, also die zeitliche Länge des ersten NF1-Signals 34 ist größer als die zeitliche Länge des zweiten NF1-Signals 34. Das zweite der Störsignale 28 ist kein NF1-Signal 34, da zwar die Frequenz des Störsignals 28 kleiner als die NF1-Frequenz 30 ist, jedoch auch der elektrische Strom 22 während der Dauer des zweiten Störsignals 28 kleiner als die NF1-Grenzschwelle 32 ist.

Ist sowohl die Frequenz der einzelnen Störsignale 28 kleiner als eine NF2-Frequenz 36, die beispielsweise 400 Hz beträgt und insbesondere gleich der Netzfrequenz 26 ist, als auch der elektrische Strom 22 größer als eine NF2-Grenzschwelle 38, die geeigneterweise gleich dem Nennstrom ist, so werden die Störsignale 28 als NF2-Signale 40 bezeichnet. Der Unterschied zwischen dem NF1-Signal 34 und dem NF2-Signal 40 sind somit lediglich die jeweiligen Schwellen der Frequenz als auch des elektrischen Stroms 22 der jeweiligen Störsignale 28. Insbesondere wird das Störsignal 28, das als NF2-Signal 40 bezeichnet wird, auch als NF1-Signal 34 bezeichnet.

Geeigneterweise analysiert der Schutzschalter 6 den zeitlichen Verlauf des elektrischen Stroms 22 und leitet daraus die Frequenz der etwaigen Störsignale 28 ab. Dies hat im Vergleich zu zum Beispiel einer Fourier-Analyse des Verlaufs des elektrischen Stroms 22 den Vorteil, dass innerhalb eines bestimmten Zeitbereichs die Frequenzen der Störsignale 28 analysiert werden können, ohne etwaige Artefakte aufgrund der zeitlichen Begrenztheit des Zeitbereichs erwarten zu müssen. Weiterhin kann hiermit der Berechnungsaufwand reduziert werden, und es existieren ebenfalls keine Einschränkungen für die Länge des zu analysierenden Zeitbereichs.

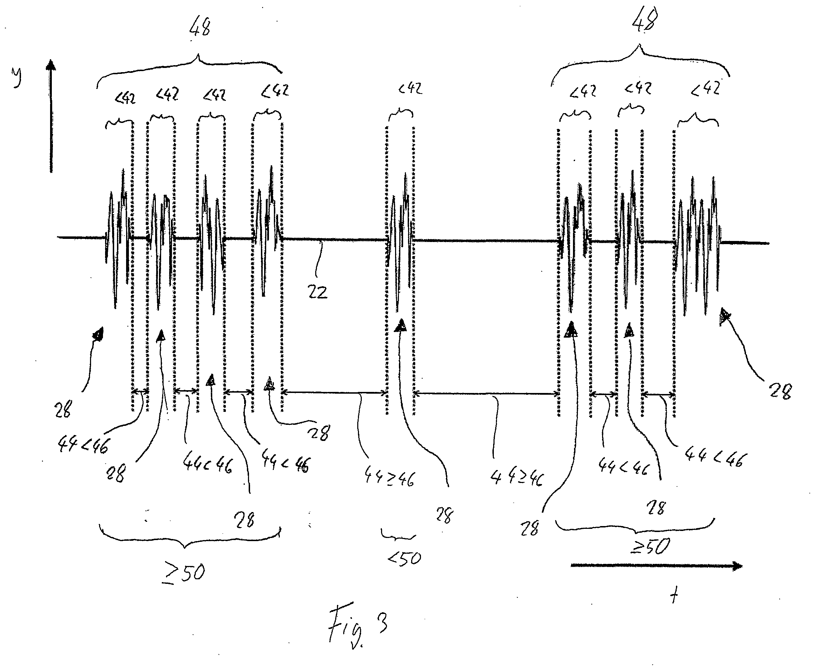

Fig. 3 zeigt einen weiteren zeitlichen Verlauf des elektrischen Stroms 22. Der elektrische Strom 22 umfasst eine Anzahl von Störsignalen 28, wobei die Frequenz jedes der Störsignale 28 kleiner als eine HF2-Frequenz 42 ist. Die HF2-Frequenz 42 beträgt beispielsweise 3,3 MHz. Jedes der Störsignale 28, deren jeweilige Länge variieren kann, weist einen zeitlichen Abstand 44 zu dem jeweiligen vorhergehenden Störsignal 28 auf. Ist für eine Anzahl zeitlich direkt aufeinander folgende Störsignale 28 der jeweilige zeitliche Abstand 44 kleiner als eine HF2-Zeit 46, so werden diese Störsignale 28 zu einem HF2-Signal 48 zusammengefasst, falls die Anzahl der derartigen Störsignale 28 eine HF2-Anzahl 50 überschreitet oder der HF2-Anzahl 50 entspricht. Die HF2-Anzahl 50 ist insbesondere zwei. Beispielsweise umfassen das erste der dargestellten HF2-Signale 48 vier Störsignale 28 und das zweite der dargestellten HF2-Signale 48 drei Störsignale 28, wobei hier das zeitlich letzte der Störsignale 28 eine vergleichsweise große Länge aufweist.

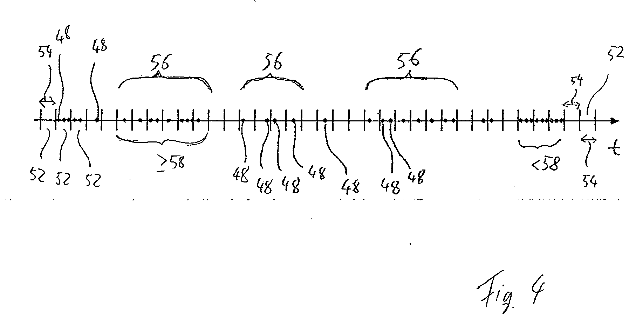

In Fig. 4 ist eine Anzahl von HF2-Signalen 48 dargestellt. Jeweils ein Punkt repräsentiert ein HF2-Signal 48, wobei die Länge der HF2-Signale 48 durchaus variieren kann. Die Zeitspanne, innerhalb der die HF2-Signale 48 gemessen werden, ist in einzelne Zeiträume 52 unterteilt. Insbesondere ist die gesamte Zeitspanne, die der Stromkreis 2 betrieben ist, in die Zeiträume 52 unterteilt. Die Länge jedes der Zeiträume 52 ist gleiche einer Anhäufungs-Länge 54, welche geeigneterweise 100µs beträgt. Alle zeitlich zusammenhängenden Zeiträume 52, innerhalb derer jeweils mindestens ein HF2-Signal 48 registriert wurde, werden zu einer Anhäufung 56 zusammengefasst, falls die Anzahl der derartigen Zeiträume 52 größer oder gleich einer Anhäufungs-Anzahl 58 ist. Die Anhäufungs-Anzahl 58 ist insbesondere gleich vier. Folglich werden mindestens vier jeweils aneinander angrenzende Zeiträume 52 zu einer der Anhäufungen 56 zusammengefasst, falls in jedem der jeweiligen Zeiträume 52 mindestens ein HF2-Signal 48 gemessen wurde. Hierbei kann der zeitliche Abstand zwischen zwei direkt aufeinanderfolgenden HF2-Signalen sowohl größer als auch kleiner als die Anhäufungs-Länge 54 sein, jedoch nicht größer als das doppelte der Anhäufungs-Länge 54. Ebenso können mehrere HF2-Signale 48 innerhalb eines der Zeiträume 52 gemessen worden sein.

Insbesondere ist die Länge jeder der Anhäufungen 56 ein Vielfaches der Anhäufungs-Länge 54. Beispielsweise umfasst der Schutzschalter 14 einen Mikroprozessor, der die HF2-Signale 48 jeweils nur in einem bestimmten zeitlichen Takt verarbeiten kann, der mit der Anhäufungs-Länge 54 korrespondiert. Insbesondere weist der Schutzschalter 14 eine Integrationseinheit auf, die sämtliche HF2-Signale 48 eines einzigen Zeitraums 52 zählt, beispielsweise mittels eines Kondensators, und die nach Ablauf des Zeitraums 52 die gemessene Anzahl an den Mikroprozessor weiterleitet.

Wird in einem der Zeiträume 52 kein HF2-Signal 48 gemessen, wobei innerhalb der direkt zeitlich vorangegangenen Zeiträumen 52, die zeitlich zusammenhängen, jeweils mindestens ein HF2-Signal 48 gemessen wurde, und wobei die Anzahl der derartigen Zeiträume kleiner als die Anhäufungs-Anzahl 58 ist, so sind diese zusammenhängenden Zeiträume 52 keine Anhäufung 56, unabhängig davon, wie viele HF2-Signale 48 insgesamt in den derartigen Zeiträumen 52 gemessen wurden. Insbesondere sind die zeitlich letzten der dargestellten Zeiträume 52, die ein HF2-Signal 48 enthalten, keine Anhäufung 56. Zwar wurden innerhalb der drei Zeiträume 52 neun HF2-Signale 48 registriert, jedoch liegt vor dem ersten und dem letzten jener Zeiträume 52, jeweils ein Zeitraum 52, der kein HF2-Signal 48 enthält. Somit ist die Anzahl der zusammenhängenden Zeiträume 52, die mindestens ein HF2-Signal 48 enthalten lediglich drei. Dagegen erfüllt die zweite der dargestellten Anhäufungen 56 die obigen Kriterien. Zwar umfasst diese Anhäufung 56 lediglich vier HF2-Signale 48, die HF2-Signale 48 liegen jedoch jeweils in einem anderen Zeitraum 52, und die Zeiträume 52 folgen zeitlich direkt aufeinander.

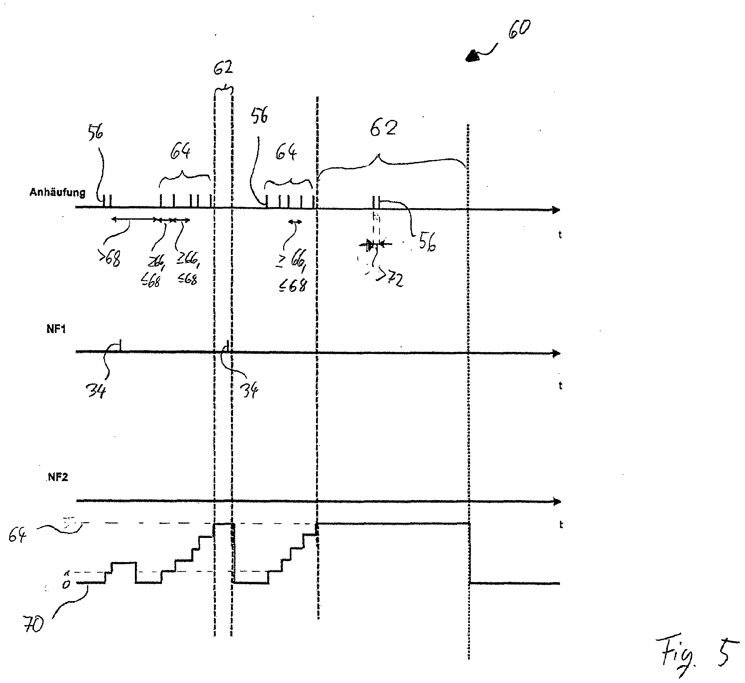

In Fig. 5 ist ein erstes Verfahren 60 zur Erkennung des Störlichtbogens 16 dargestellt, das nicht der Erfindung entspricht.

Oben ist der zeitliche Verlauf der Messung von einer Anzahl von Anhäufungen 56 innerhalb des Stromkreises 2 dargestellt. Jeder Strich symbolisiert eine Anhäufung 56, wobei die Länge jeder der Anhäufungen 56 variieren kann. Darunter ist der zeitliche Verlauf der Messung von NF1-Signalen 34 und wiederum darunter der der Messung von NF2-Signalen 40 gezeigt. Auch hierbei variiert die Länge der NF1-Signalen 34, wohingegen zum Beispiel kein NF2-Signal 40 gemessen wird.

Falls eine Anzahl von Anhäufungen 56 auftritt, wird eine Warteperiode 62 gestartet, die insbesondere 100ms beträgt. Die Anzahl der Anhäufungen 56, die zu dem Start führen, ist gleich einem Anhäufungswert 64, der insbesondere fünf beträgt. Hierbei ist der zeitliche Abstand zwischen jeweils zweien der Anhäufungen 56 größer oder gleich einer erste Anhäufungs-Zeit 66 und kleiner oder gleich einer zweiten Anhäufungs-Zeit 68. Die erste Anhäufungs-Zeit 66 beträgt beispielsweise 1,6ms und die zweite Anhäufungs-Zeit 68 ist insbesondere 23ms. Geeigneterweise werden die Anhäufungen 56 mittels eines WET1-Anhäufungszählers 70 gezählt. Jeweils zu Beginn des Verfahrens 60 wird der WET1-Anhäufungszählers 70 auf null (0) gesetzt. Für jeden Fall, bei dem der WET1-Anhäufungszähler 70 null (0) beträgt, wird der Zählerstand des WET1-Anhäufungszählers 70 um eins (1) erhöht, sobald eine Anhäufung 56 innerhalb des elektrischen Stroms 22 des Stromkreises 2 erkannt wird. Immer wenn nach einer Erhöhung des WET1-Anhäufungszählers 70 eine weitere Anhäufung 56 folgt, deren zeitlicher Abstand zu der zeitlich vorhergehenden Anhäufung 56 größer oder gleich der erste Anhäufungs-Zeit 66 und kleiner oder gleich der zweiten Anhäufungs-Zeit 68 ist, wird der WET1-Anhäufungszähler 70 ein weiteres Mal erhöht. Ist der zeitliche Abstand zweier aufeinanderfolgender Anhäufungen 56 kleiner oder größer als die erste Anhäufungs-Zeit 66 bzw. die zweite Anhäufungs-Zeit 68, wird der WET1-Anhäufungszähler auf null (0) zurückgesetzt.

Nach dem Erreichen des Anhäufungswertes 64 durch den Zählerstand des WET1-Anhäufungszählers 70 wird die Warteperiode 62 gestartet. Falls innerhalb der Warteperiode 64 ein NF1-Signal 34 gemessen wird oder zwei aufeinanderfolgende Anhäufungen 56 einen zeitlichen Abstand aufweisen, der kleiner als eine dritte Anhäufungs-Zeit 72 ist, so wird die Warteperiode 62 abgebrochen und der WET1-Anhäufungszähler 70 auf null (0) gesetzt. Geeigneterweise ist die dritte Anhäufungs-Zeit 72 gleich 1,5ms. Anhäufungen 56, die einen zeitlichen Abstand aufweisen, der größer als die dritte Anhäufungs-Zeit 72 ist, haben beispielsweise keinen Einfluss auf die Warteperiode 62 und den WET1-Anhäufungszählers 70.

Nachdem Abbruch der Warteperiode 62 wird bei jeder weiteren Anhäufung 56 der WET1-Anhäufungszähler um eins (1) erhöht, solange die Anhäufungen 56 die obigen Kriterien erfüllen. Falls innerhalb der Warteperiode 62 kein NF1-Signal 34 gemessen wird, und etwaige Anhäufungen 56 einen zeitlichen Abstand aufweisen, der größer als die dritte Anhäufungs-Zeit 72 ist, wird eine Meldung 74 des Störlichtbogens 16 ausgegeben.

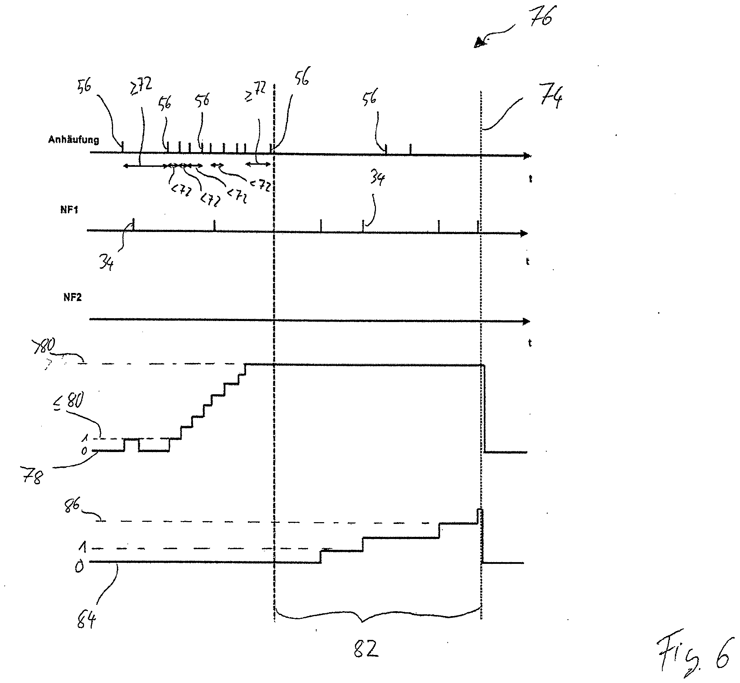

Fig. 6 zeigt ein weiteres Verfahren 76 zur Erkennung des Störlichtbogens 16 gemäß Fig. 5. Bei diesem Verfahren 76 werden die in dem elektrischen Strom 22 vorhandenen Anhäufungen 56 gezählt. Im Gegensatz zu dem obigen Verfahren 60 werden bei diesem Verfahren 76 nur die Anhäufungen 56 gezählt, deren zeitlicher Abstand kleiner als die dritte Anhäufungs-Zeit 72 ist.

Zweckmäßigerweise wird hierbei ein WET2-Anhäufungszähler 78 verwendet. Zu Beginn des Verfahrens 76 wird der Zählerstand des WET2-Anhäufungszählers 78 auf null (0) gesetzt. Jedes Mal wenn der WET2-Anhäufungszähler 78 null (0) beträgt wird der Zählerstand des WET2-Anhäufungszählers 78 um eins (1) erhöht, sobald eine Anhäufung 56 innerhalb des elektrischen Stroms 22 des Stromkreises 2 erkannt wird. Bei jeder weiteren identifizierten Anhäufung 56, deren zeitlicher Abstand zu der zeitlich direkt vorrangegangenen Anhäufung 56 kleiner als die dritte Anhäufungs-Zeit 72 ist, wird der WET2-Anhäufungszählers 78 um eins (1) erhöht. Sobald eine Anhäufung 56 einen zeitlichen Abstand zu der vorherigen Anhäufung 56 aufweist, der größer als die dritte Anhäufungs-Zeit 72 ist, wird der WET2-Anhäufungszählers 78 überprüft. Ist der Zählerstand kleiner oder gleich einem ersten WET2-Grenzwert 80, so wird der WET2-Anhäufungszählers 78 auf null (0) zurückgesetzt. Übersteigt der WET2-Anhäufungszählers 78 den ersten WET2-Grenzwert 80, so wird eine NF-Periode 82 gestartet. Der erste WET2-Grenzwert 80 ist geeigneterweise sechs und die NF-Periode 82 ist insbesondere 20ms.

Innerhalb der NF-Periode 82 wird ein NF1-Zähler 84 aktiv. Zu Beginn der NF-Periode 82 wird der NF1-Zähler 84 auf null (0) gesetzt, und mit jedem innerhalb der NF-Periode 82 gemessenen NF1-Signal 34 um eins (1) erhöht. Überschreitet der NF1-Zähler 84 einen zweiten WET2-Grenzwert 86, so wird die Meldung 74 des Störbogens 16 ausgegeben und insbesondere die NF-Periode 82 beendet. Vorteilhafterweise ist der zweite WET2-Grenzwert 86 gleich drei. Falls nach der NF-Periode 82 die Anzahl der gemessenen NF1-Signale 34 kleiner oder gleich dem zweiten WET2-Grenzwert 86 ist, werden der NF1-Zähler 84 und der WET2-Anhäufungszählers 78 auf null (0) gesetzt und das Verfahren 76 neugestartet.

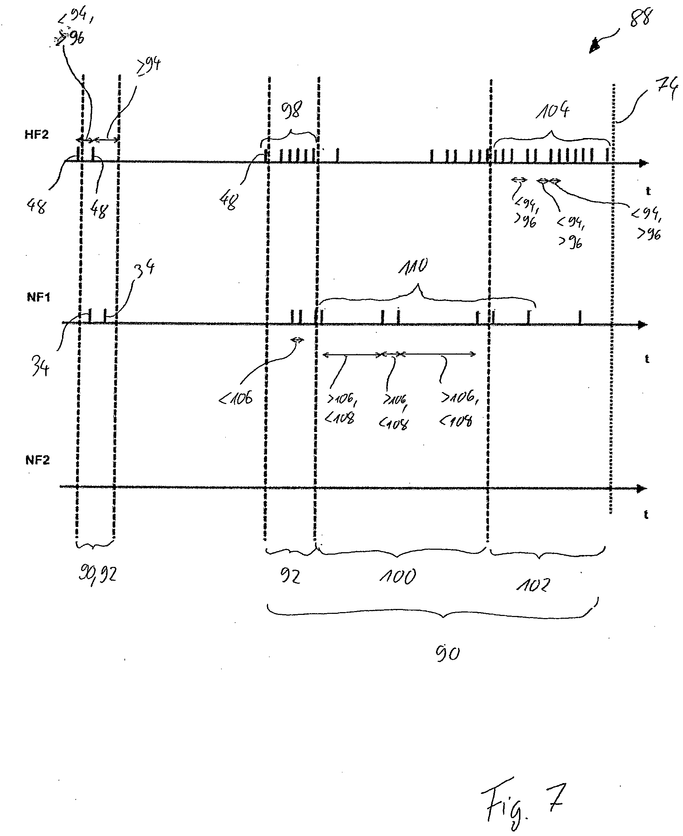

Ein Verfahren 88 zur Erkennung des Störlichtbogens 16 gemäß der vorliegenden Erfindung ist in Fig. 7 dargestellt.

Oben ist der zeitliche Verlauf der Messung von einer Anzahl der HF2-Signale 48 innerhalb des Stromkreises 2 dargestellt. Jeder Strich symbolisiert eines der HF2-Signale 48, wobei die Länge jedes der HF2-Signale 48 variieren kann. In der Mitte ist der zeitliche Verlauf der Messung der NF1-Signale 34 und unten der zeitliche Verlauf der Messung von NF2-Signalen 40 gezeigt. Auch hierbei variiert die Länge der NF1-Signalen 34, wohingegen zum Beispiel kein NF2-Signal 40 gemessen wird.

Jedes in dem elektrischen Strom 22 vorhandene HF2-Signal 48, das außerhalb eines Seriellzeitraums 90 gemessen wurde, startet einen Seriellzeitraum 90, welcher mit einer ersten Messphase 92 beginnt. Das den Seriellzeitraum 90 startende HF2-Signal 48 zählt zu dem Seriellzeitraum 90 sowie zur ersten Messphase 92 und ist lediglich zur Verdeutlichung zeitlich geringfügig früher dargestellt. In der ersten Messphase 92 werden die etwaigen, in dem elektrischen Strom 22 vorhandenen HF2-Signale 48 gezählt. Hierbei werden jedoch nur die HF2-Signale 48 gezählt, deren zeitlicher Abstand zu dem jeweiligen, zeitlich direkt vorangegangenen HF2-Signal 48 zwischen einer dritten Abbruch-Zeitspanne 94 und einer vierten Abbruch-Zeitspanne 96 liegt. Vorzugsweise ist die dritte Abbruch-Zeitspanne 94 gleich 200ms und die vierten Abbruch-Zeitspanne 96 beträgt zum Beispiel 300µs.

Falls innerhalb der ersten Messphase 92 der zeitliche Abstand zwischen zwei zeitlich direkt aufeinanderfolgenden HF2-Signalen 48 größer als die dritte Abbruch-Zeitspanne 94 ist, wird sowohl die ersten Messphase 92 als auch der Seriellzeitraum 90 abgebrochen. Mit anderen Worten wird die erste Messphase 92 und der Seriellzeitraum 90 abgebrochen, wenn für die dritte Abbruch-Zeitspanne 94 nach dem zeitlich letzten HF2-Signal 48 kein weiteres HF2-Signal gemessen wird. Dies ist beispielsweise nach dem zweiten der dargestellten HF2-Signale 48 der Fall.

Wird innerhalb der ersten Messphase 92 eine Anzahl von HF2-Signalen 48 einschließlich des den Start des Seriellzeitraums 90 bewirkenden HF2-Signals 48 gezählt, welche Anzahl gleich einer ersten Seriellen-Anzahl 98 ist, so wird die erste Messphase 92 beendet und eine Halteperiode 100 gestartet. Die erste Seriellen-Anzahl 98 ist zum Beispiel sechs. Innerhalb der Halteperiode 100 werden insbesondere etwaige gemessene HF2-Signale 48 nicht berücksichtigt. Das bedeutet, dass weder deren Anzahl, noch deren jeweilige Länge oder der zeitliche Abstand zwischen zwei HF2-Signalen 48 eine Auswirkung auf die Halteperiode 100 haben. Die Halteperiode 100 ist geeigneterweise zwischen 30ms und 220ms lang. Beispielsweise ist die Länge der Halteperiode 100 von der Größe des elektrischen Stroms 22 und insbesondere von dessen Nennstrom abhängig. Bei einem vergleichsweise großen Nennstrom ist die Halteperiode 100 zum Beispiel größer als bei einem vergleichsweise kleinen Nennstrom. Vorteilhafterweise ist die Länge der Halteperiode 100 während des Betriebs des elektrischen Stromkreises 2 veränderbar.

An die Halteperiode 100 schließt sich direkt eine zweite Messphase 102 an. Innerhalb der zweiten Messphase 102 werden, vergleichbar mit der ersten Messphase 98, diejenigen HF2-Signale 48 gezählt, deren zeitlicher Abstand zu dem jeweiligen, zeitlich direkt vorangegangenen HF2-Signal 48 zwischen der dritten Abbruch-Zeitspanne 94 und der vierten Abbruch-Zeitspanne 96 liegt. Ebenso wird auch die zweiten Messphase 102 und der Seriellzeitraum 90 abgebrochen, falls innerhalb der zweiten Messphase 102 der zeitliche Abstand zwischen zwei zeitlich direkt aufeinanderfolgenden HF2-Signalen 48 größer als die dritte Abbruch-Zeitspanne 94 ist.

Die zweite Messphase 102 wird beendet, falls innerhalb der zweiten Messphase 102 die Anzahl der gemäß obiger Beschreibung gezählten HF2-Signale 48 einer zweiten Seriellen-Anzahl 104 entspricht. Vorzugsweise ist die zweite Seriellen-Anzahl 104 gleich zwölf. Mit der zweiten Messphase 102 wird auch der Seriellzeitraum 90 beendet. Nach dem Beenden der zweiten Messphase 102 werden die innerhalb des gesamten Seriellzeitraums 90 gezählten NF1-Signale 34 überprüft, deren zeitlicher Abstand zueinander zwischen einer fünften Abbruch-Zeitspanne 106 und einer sechsten Abbruch-Zeitspanne 108 liegt. Die fünfte Abbruch-Zeitspanne 106 ist vorteilhafterweise gleich 8,3ms und die sechste Abbruch-Zeitspanne 108 beträgt zweckmäßigerweise 200ms. Ist die Anzahl der derartigen NF1-Signale 34 größer als eine dritte Seriellen-Anzahl 110, so wird der Störlichtbogen 16 gemeldet.

Geeigneterweise ist die dritte Seriellen-Anzahl 110 gleich sechs. Die Meldung 74 des Störlichtbogens wird ebenfalls ausgegeben, falls die Anzahl der derartigen NF1-Signale 34 gleich der dritte Seriellen-Anzahl 110 ist, und nach dem zeitlich letzten der derartigen NF1-Signale 34 für zumindest einen Zeitraum, der größer oder gleich der fünften Abbruch-Zeitspanne 106 ist, kein weiteres NF1-Signal 34 in dem elektrischen Strom 22 gemessen wurde.

Innerhalb des zweiten der dargestellten Seriellzeiträume 90 sind sieben derartige NF1-Signale 34 gezeigt. Beispielsweise weisen die beiden ersten NF1-Signale 34 des zweiten Seriellzeitraums 90 einen zeitlichen Abstand zueinander auf, der kleiner als die fünfte Abbruch-Zeitspanne 106 ist, weswegen diese beiden NF1-Signale 34 bei der Überprüfung nicht berücksichtigt werden. Der jeweilige zeitliche Abstand aller weiteren NF1-Signale 34 des zweiten Seriellzeitraums 90 liegt hingegen zwischen der fünften Abbruch-Zeitspanne 106 und der sechsten Abbruch-Zeitspanne 108.

Etwaige vor oder nach den derartigen NF1-Signalen 34 innerhalb des Seriellzeitraums 90 zusätzlich gemessene NF1-Signale 34 haben vorzugsweise keine Auswirkung auf die Meldung 74 des Störlichtbogens 16.

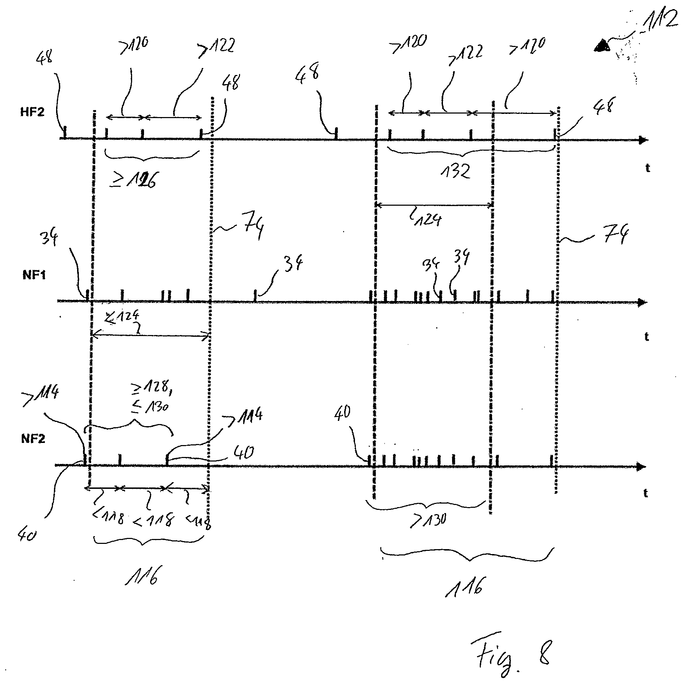

Fig. 8 zeigt ein weiteres Verfahren 112 zur Erkennung des Störlichtbogens 16, das nicht der vorliegenden Erfindung entspricht.

Sobald ein NF2-Signal 40, dessen Länge größer als eine NF2-Grenzlänge 114 ist, außerhalb eines Parallelzeitraums 116 gemessen wird, wird der Parallelzeitraum 116 gestartet. Auch hierbei zählt - vergleichbar mit dem in Fig. 7 dargestellten Verfahren 88 - das den Parallelzeitraum 116 startende NF2-Signal 40 zu dem Parallelzeitraum 116. Die NF2-Grenzlänge 114 ist zum Beispiel gleich 200µs. Während des Parallelzeitraums 116 werden alle NF2-Signale 40 gezählt, deren Länge größer als die oder gleich der NF2-Grenzlänge 114 ist, und der Parallelzeitraums 116 wird abgebrochen, falls eine der Längen der NF2-Signale 40 kleiner als die NF2-Grenzlänge 114 ist. Der Parallelzeitraum 116 wird ebenfalls abgebrochen, falls für eine zweite Abbruch-Zeitspanne 118 innerhalb des Parallelzeitraums 116 kein NF2-Signal 40 gemessen wird. Insbesondere ist die zweite Abbruch-Zeitspanne 118 gleich 500ms. Ebenso führt eine elektrische Spannung 24, die während des Parallelzeitraums 116 für eine erste Abbruch-Zeitspanne kleiner als eine Abbruch-Spannung ist, zu einem Abbruch des Parallelzeitraums 116. Hierbei ist beispielsweise die Abbruch-Spannung gleich 15V und die erste Abbruch-Zeitspanne beträgt insbesondere 3,2ms.

Zusätzlich zu den NF2-Signalen 40 werden innerhalb des Parallelzeitraums 116 die HF2-Signale 48 gezählt, deren zeitlicher Abstand zu dem jeweiligen, zeitlich direkt vorangegangenen HF2-Signal 48 größer oder gleich einer ersten Störlichtbogen-Zeitspanne 120 ist, welche insbesondere 500µs beträgt. Ferner wird überprüft, ob einer der Abstände größer als eine zweite Störlichtbogen-Zeitspanne 122 ist. Falls dies der Fall ist, und sowohl die Anzahl der insgesamt innerhalb einer dritten Störlichtbogen-Zeitspanne 124 gemessenen HF2-Signale 48 größer oder gleich einer ersten Störlichtbogen-Anzahl 126 ist, als auch die Anzahl der innerhalb der dritten Störlichtbogen-Zeitspanne 124 gemessen NF2-Signale 40 größer oder gleich einer zweiten Störlichtbogen-Anzahl 128 und kleiner oder gleich einer dritten Störlichtbogen-Anzahl 130 ist, wird der Störlichtbogen 16 gemeldet. Die dritte Störlichtbogen-Zeitspanne 124 beginnt mit dem Parallelzeitraum 116 und ist geeigneterweise 25ms lang. Beispielsweise ist die erste Störlichtbogen-Anzahl 126 drei, die zweite Störlichtbogen-Anzahl 128 ist insbesondere drei, und die dritte Störlichtbogen-Anzahl 130 ist vorzugsweise sieben.

In der Figur 8 weisen beispielsweise alle NF2-Signale 40 eine zeitliche Länge auf, die größer als die NF2-Grenzlänge 114 ist, und mit dem zeitlich ersten NF2-Signal 40 wird der erste der beiden dargestellten Parallelzeitraum 116 gestartet. Innerhalb dieses Parallelzeitraums 116 werden einschließlich des NF2-Signals 40, das den Start dieses Parallelzeitraums 116 auslöst, drei NF2-Signale 40 gemessen, wobei diese Anzahl der zweiten Störlichtbogen-Anzahl 128 entspricht. Während des Parallelzeitraums 116 werden ebenfalls drei HF2-Signale 48 gemessen, wobei diese Anzahl gleich der ersten Störlichtbogen-Anzahl 126 ist. Der Abstand zwischen dem ersten und dem zweiten der HF2-Signale 48 ist größer als die erste Störlichtbogen-Zeitspanne 120, und der Abstand zwischen dem zweiten und dem dritten der HF2-Signale 48 ist größer als die zweite Störlichtbogen-Zeitspanne 122. Da innerhalb der dritten Störlichtbogen-Zeitspanne 124 drei NF2-Signale 40 gemessen wurden, wird nach dem zeitlich letzten der drei HF2-Signale 48 sowohl der Parallelzeitraum 116 beendet als auch der Störlichtbogen 16 gemeldet.

Das vierte der NF2-Signale 40 startet den zweiten der dargestellten Parallelzeiträume 116. Die zeitliche Abfolge der innerhalb des zweiten der Parallelzeiträume 116 gemessenen HF2-Signale 48 ist zum Beispiel gleich der zeitlichen Abfolge der innerhalb des ersten der Parallelzeiträume 116 gemessenen HF2-Signale 48. Innerhalb der dritten Störlichtbogen-Zeitspannen 124 werden einschließlich des NF2-Signals 40, das den Start des zweiten der Parallelzeiträume 116 auslöst, neun NF2-Signale 40 gemessen. Diese Anzahl ist größer als die dritte Störlichtbogen-Anzahl 130, weswegen nach dem dritten der innerhalb des zweiten der Parallelzeiträume 116 gemessenen Hf2-Signale 48 der zweite Parallelzeitraum 116 nicht beendet wird. Erst wenn eine Anzahl von HF2-Signalen 40 gemessen wurde, die einer vierten Störlichtbogen-Anzahl 132 entspricht, wird der Störlichtbogen 16 gemeldet. Die vierte Störlichtbogen-Anzahl 132 ist insbesondere vier, weswegen nach dem Messen des vierten HF2-Signals 48 des zweiten Parallelzeitraums 116 die Meldung 74 des Störlichtbogens 16 ausgegeben wird, wobei der zeitliche Abstand dieses HF2-Signals 48 zu dessen zeitlich direkt vorangegangenem HF2-Signal 48 größer oder gleich der ersten Störlichtbogen-Zeitspanne 120 ist.

Das Verfahren 112 kann abwechselnd mit zumindest einem weiteren, vorzugsweise allen, der obigen Verfahren 60, 76, 88 ablaufen. Hierbei wird das weitere Verfahren unterbrochen, wenn eines der NF2-Signal 40 gemessen wird, dessen Länge größer als die NF2-Grenzlänge 114 ist. Während des Parallelzeitraums 116 wird das weitere Verfahren angehalten, was bedeutet, dass mit Ausnahme der für das Verfahren 112 benötigten Signale, nämlich die HF2-Signale 48 und die NF2 Signale 40, kein weiteres Signal wie zum Beispiel die NF1-Signale 34 oder die Anhäufungen 56 weiterverarbeitet werden. Die HF2-Signale 48 werden zudem lediglich insofern berücksichtigt, als sie zu dem Verfahren 112 beitragen. Insbesondere werden weder der WET1-Anhäufungszähler 70, noch der WET2-Anhäufungszähler 78 oder der NF1-Zähler 84 innerhalb des Parallelzeitraums 116 verändert. Nach dem Abbruch oder der Beendigung des Parallelzeitraums 116 wird das weitere Verfahren neu gestartet, was insbesondere ein Zurücksetzen des oder der jeweiligen Zähler auf null (0) zur Folge hat.

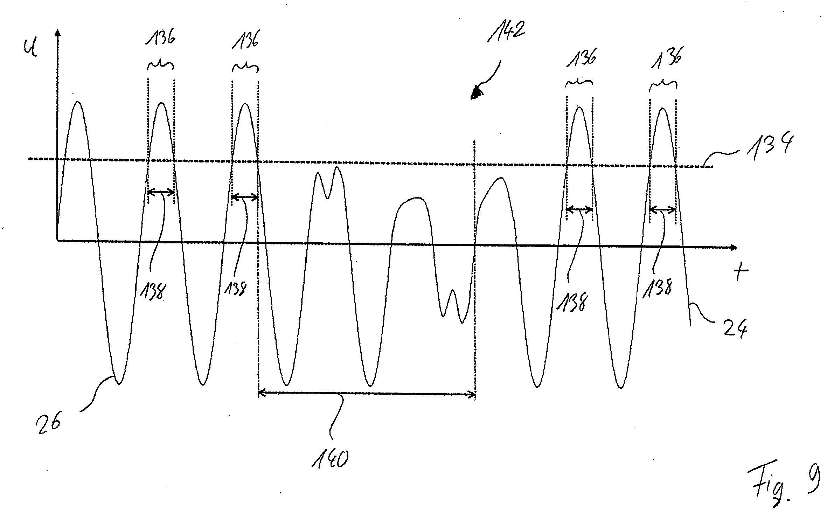

In Fig. 9 ist der zeitliche Verlauf der elektrischen Spannung 24 dargestellt, welcher im Wesentlichen sinusförmig ist. Aufgrund der zeitlichen Periodizität der elektrischen Spannung 24 überschreitet diese im Normalbetrieb regelmäßig einen Grenzwert, der als SPG-Spannung 134 bezeichnet wird. Die SPG -Spannung 134 ist kleiner als die Nennspannung und beträgt vorzugsweise 90V. Der Zeitraum, innerhalb dessen die elektrische Spannung 24 größer als die SPG -Spannung 134 ist, wird als eine Hochzeitspanne 136 bezeichnet. Im Normalbetrieb ist die Länge 138 aller Hochzeitspannen 136 im Wesentlichen gleich und konstant sowie zudem abhängig von der Netzfrequenz 26. Beispielsweise beträgt die Länge 138 im Normalbetrieb 600µs. Ebenfalls ist der zeitliche Abstand zwischen den einzelnen Hochzeitspannen 136 im Wesentlichen gleich und konstant sowie abhängig von der Netzfrequenz 26. Der zeitliche Abstand im Normalbetrieb ist reziprok zur Netzfrequenz 26 - also 2,5ms - abzüglich der Länge 138 der Hochzeitspanne 136. Insbesondere ist der zeitliche Abstand 1,9ms.

Treten zum Beispiel eines oder mehrere der Störsignale 28 oder der Störlichtbogen 16 auf, oder ist die Leistungsentnahme des Verbrauchers 10 zeitlich wechselhaft, so ist es möglich, dass der Verlauf der elektrischen Spannung 24 von der Sinusform abweicht. Beispielsweise haben derartige Beeinflussungen der elektrischen Spannung 24 zur Folge, dass die Frequenz der elektrischen Spannung 24 gestört wird, also dass die Frequenz nicht konstant ist, oder dass das Maximum der elektrischen Spannung 24 für einen Zeitraum, der größer als das Doppelte des Reziproken der Netzfrequenz 26 ist, kleiner als die Nennspannung ist. Falls sich daher die Längen 138 zweier aufeinanderfolgender Hochzeitspannen 136 um mehr als eine dritte SPG-Zeitspanne unterscheiden, oder für eine zweite SPG-Zeitspanne 140 die elektrische Spannung 24 nicht die SPG -Spannung 134 überschreitet, ist ein Problem der elektrischen Spannung 24 identifiziert, welches als SPG-Fehler 142 bezeichnet wird. Die dritte SPG-Zeitspanne ist geeigneterweise 100µs und die zweite SPG-Zeitspanne beträgt insbesondere 6,4ms.

Vorteilhafterweise wird in Fällen, in denen ein SPG-Fehler 142 innerhalb der elektrischen Spannung 24 identifiziert wird, zumindest eines der obigen Verfahren 76, 88 abgebrochen und für einen Zeitraum, der eine Länge einer ersten SPG-Zeitspanne aufweist, nicht erneut gestartet. Insbesondere werden weder der WET2-Anhäufungszähler 78 noch der NF1-Zähler 84 innerhalb der ersten SPG-Zeitspanne nach dem SPG-Fehler 140 verändert. Nach der ersten SPG-Zeitspanne werden das oder die Verfahren 76, 88 neu gestartet, was insbesondere ein Zurücksetzen der jeweiligen Zähler auf null (0) zur Folge hat. Die SPG-Zeitspanne beträgt geeigneterweise 1s.

**Bezugszeichenliste**

| | | | |
|---|---|---|---|
| 2 | Stromkreis | 56 | Anhäufung |
| 4 | Stromquelle | 58 | Anhäufungs-Anzahl |
| 5 | Anschluss | 60 | Verfahren |
| 6 | Anschluss | 62 | Warteperiode |
| 8 | elektrische Leitung | 64 | Anhäufungswert |
| 10 | Verbraucher | 66 | erste Anhäufungs-Zeit |
| 12 | elektrische Leitung | 68 | zweite Anhäufungs-Zeit |
| 14 | Schutzschalter | 70 | WET1-Anhäufungszähler |
| 16 | Störlichtbogen | 72 | dritte Anhäufungs-Zeit |
| 17 | Unterbrechungseinheit | 74 | Meldung |
| 18 | mit Masse verbundenes Element | 76 | Verfahren |
| 20 | Bereich poröser Isolierung | 78 | WET2-Anhäufungszähler |
| 22 | Strom | 80 | erster WET2-Grenzwert |
| 24 | Spannung | 82 | NFPeriode |
| 26 | Netzfrequenz | 84 | NF1-Zähler |
| 28 | Störsignal | 86 | zweiter WET2-Grenzwert |
| 30 | NF1-Frequenz | 88 | Verfahren |
| 32 | NF1-Grenzschwelle | 90 | Seriellzeitraum |
| 34 | NF1-Signal | 92 | erste Messphase |
| 36 | NF2-Frequenz | 94 | dritte Abbruch-Zeitspanne |
| 38 | N F2-Grenzschwelle | 96 | vierte Abbruch-Zeitspanne |
| 40 | NF2-Signal | 98 | erste Seriellen-Anzahl |
| 42 | HF2-Frequenz | 100 | Halteperiode |
| 44 | zeitlicher Abstand | 102 | zweite Messphase |
| 46 | HF2-Zeit | 104 | zweite Seriellen-Anzahl |
| 48 | HF2-Signal | 106 | fünfte Abbruch-Zeitspanne |
| 50 | HF2-Anzahl | 108 | sechste Abbruch-Zeitspanne |
| 52 | Zeitraum | 110 | dritte Seriellen-Anzahl |
| 54 | Anhäufungs-Länge | 112 | Verfahren |
| 114 | | NF2-Grenzlänge | |
| 116 | | Parallelzeitraum | |
| 118 | | zweite Abbruch-Zeitspanne | |
| 120 | | erste Störlichtbogen-Zeitspanne | |
| 122 | | zweite Störlichtbogen-Zeitspanne | |
| 124 | | dritte Störlichtbogen-Zeitspanne | |
| 126 | | erste Störlichtbogen-Anzahl | |
| 128 | | zweite Störlichtbogen-Anzahl | |
| 130 | | dritte Störlichtbogen-Anzahl | |
| 132 | | vierte Störlichtbogen-Anzahl | |
| 134 | | SPG-Spannung | |
| 136 | | Hochzeitspanne | |
| 138 | | Länge | |
| 140 | | zweite SPG-Zeitspanne | |
| 142 | | SPG -Fehler | |

## Patentansprüche

1. Verfahren (88) zur Erkennung von Störlichtbögen (16) innerhalb eines eine Netzfrequenz (26), einen elektrischen Strom (22) und eine elektrische Spannung (24) aufweisenden Stromkreises (2),
- bei dem ein auftretendes Störsignal (28), das eine Frequenz unterhalb einer NF1-Frequenz (30) und eine Stromstärke des elektrischen Stroms des Stromkreises oberhalb einer NF1-Grenzschwelle (32) aufweist, ein NF1-Signal (34) definiert,
- bei dem eine Anzahl von auftretenden Störsignalen (28), die eine Frequenz unterhalb einer HF2-Frequenz (42) aufweisen, zu einem HF2-Signal (48) zusammengefasst werden, wenn die Anzahl der Störsignale (28) größer oder gleich einer HF2-Anzahl (50) ist, und falls der zeitliche Abstand zweier aufeinanderfolgender Störsignale (28) kleiner als eine HF2-Zeit (46) ist,
- bei dem ein HF2-Signal (48) einen Seriellzeitraum (90) startet, und
- bei dem der Störlichtbogen (16) erkannt und/oder gemeldet wird,
∘ wenn in einer ersten Messphase (92) des Seriellzeitraums (90) eine Anzahl von HF2-Signalen (48) gemessen werden, deren zeitlicher Abstand zwischen jeweils zwei aufeinanderfolgenden HF2-Signale (48) zwischen einer vierten Abbruch-Zeitspanne (96) und einer dritte Abbruch-Zeitspanne (94) beträgt, wenn die Anzahl der HF2-Signale (48) gleich einer ersten Seriellen-Anzahl (98) ist,
∘ wenn in einer zweiten Messphase (102), die eine Halteperiode (100) nach der ersten Messphase (92) beginnt, eine weitere Anzahl von HF2-Signale (48) gemessen wurde, deren zeitlicher Abstand zwischen jeweils zwei aufeinanderfolgenden HF2-Signale zwischen der vierten Abbruch-Zeitspanne (96) und der dritte Abbruch-Zeitspanne (94) beträgt, wenn die weitere Anzahl der HF2-Signale (48) gleich einer zweiten Seriellen-Anzahl (104) ist, und
∘ wenn innerhalb des Seriellzeitraums (90) eine Anzahl von NF1-Signalen (34) gemessen wurde, welche Anzahl gleich einer dritten Seriellen-Anzahl (119) ist, wobei der zeitliche Abstand zwischen zwei aufeinanderfolgenden NF1-Signalen (34) zwischen einer fünften Abbruch-Zeitspanne (106) und einer sechsten Abbruch-Zeitspanne (108) liegt, und wenn nach dem letzten der NF1-Signale (34) für zumindest eine Zeitspanne, die der fünften Abbruch-Zeitspanne (106) entspricht, kein weiteres NF1-Signal (34) gemessen wurde, und
- bei dem der Seriellzeitraum (90) beendet wird, falls in einer der Messphasen (92, 102) der zeitliche Abstand zweier direkt aufeinanderfolgender HF2-Signale (48) größer als die dritte Abbruch-Zeitspanne (94) ist.

2. Verfahren nach Anspruch 1, bei dem der Seriellzeitraum (90) beendet wird, falls dieser bereits begonnen hat, und der Seriellzeitraum (90) für eine erste SPG-Zeitspanne nicht gestartet wird, wenn entweder für eine zweite SPG-Zeitspanne (140) die Spannung (24) nicht größer als eine SPG-Spannung (134) ist, oder sich die Längen zweier aufeinanderfolgender Hochzeitspannen (136) um mehr als eine dritte SPG-Zeitspanne unterscheiden, wobei die Hochzeitspannen (136) die Zeitspanne ist, innerhalb derer die Spannung (24) größer als die SPG-Spannung (134) ist.

3. Verfahren nach Anspruch 1 oder 2, bei dem der Seriellzeitraum (90) beendet wird, falls dieser bereits begonnen hat, und der Seriellzeitraum (90) für einen Parallelzeitraum (116) nicht gestartet wird, falls ein NF2-Signal (40) gemessen wird, das länger als eine NF2-Grenzlänge (114) andauert,
- wobei ein auftretendes Störsignal (28), das eine Frequenz unterhalb einer NF2-Frequenz (36) und eine Stromstärke des elektrischen Stroms des Stromkreises oberhalb einer NF2-Grenzschwelle (38) aufweist, als NF2-Signal (40) bezeichnet wird, und
- wobei der Parallelzeitraum (116) beendet wird, wenn
∘ ein gemessenes NF2-Signal (40) kürzer als die NF2-Grenzlänge (114) andauert, oder
∘ die Spannung (24) für eine ersten Abbruch-Zeitspanne kleiner einer Abbruch-Spannung war, oder
∘ für eine zweite Abbruch-Zeitspanne (118) kein NF2-Signal (40) gemessen wurde, und
- wobei der Störlichtbogen (16) erkannt bzw. gemeldet wird,
∘ wenn innerhalb des Parallelzeitraums (116) zwischen allen aufeinanderfolgenden HF2-Signalen (48) der zeitliche Abstand größer oder gleich einer ersten Störlichtbogen-Zeitspanne (120) ist,
∘ wenn innerhalb des Parallelzeitraums (116) zwischen zwei direkt aufeinanderfolgenden HF2-Signalen (48) der zeitliche Abstand größer oder gleich einer zweiten Störlichtbogen-Zeitspanne (122) ist, und
∘ wenn entweder eine Anzahl von HF2-Signalen (48) gemessen wurde, die größer oder gleich einer ersten Störlichtbogen-Anzahl (126) ist, falls innerhalb einer dritten Störlichtbogen-Zeitspanne (124) eine Anzahl von NF2-Signale (40) gemessen wurde, die zwischen einer zweiten Störlichtbogen-Anzahl (128) und einer dritten Störlichtbogen-Anzahl (130) liegt, oder wenn eine Anzahl HF2-Signale (48) gemessen wurde, die größer oder gleich einer vierten Störlichtbogen-Anzahl (132) ist, falls innerhalb der dritten Störlichtbogen-Zeitspanne (124) eine Anzahl von NF2-Signale(40) gemessen wurde, die größer als die dritten Störlichtbogen-Anzahl (130) ist, wobei jeweils die dritten Störlichtbogen-Zeitspanne (130) mit dem Parallelzeitraum (116) beginnt.

4. Schutzschalter (14), der dazu vorgesehen und eingerichtet ist das Verfahren nach einem der Ansprüche 1 bis 3 durchzuführen.

5. Schutzschalter (14) nach Anspruch 4,
**gekennzeichnet durch**
eine Unterbrechungseinheit (17) zur Unterbrechung eines Stromkreises (2), sobald der Störlichtbogen (16) erkannt bzw. gemeldet ist.

## Claims

1. Method (88) for identifying arcing faults (16) within a circuit (2) having a mains frequency (26), an electric current (22) and an electric voltage (24),
- in which method an emerging interference signal (28) that has a frequency below an NF1 frequency (30) and a current intensity of the electric current of the circuit above an NF1 threshold value (32) defines an NF1 signal (34),
- in which method a number of emerging interference signals (28) that have a frequency below an HF2 frequency (42) are combined to form an HF2 signal (48) when the number of interference signals (28) is greater than or equal to an HF2 number (50), and if the time interval of two successive interference signals (28) is smaller than an HF2 time (46),
- in which method an HF2 signal (48) starts a serial time period (90), and
- in which method the arcing fault (16) is identified and/or reported,
∘ when, in a first measuring phase (92) of the serial time period (90), a number of HF2 signals (48) is measured, the time interval of which between two respective successive HF2 signals (48) is between a fourth termination timespan (96) and a third termination timespan (94), when the number of HF2 signals (48) is equal to a first serial number (98),
∘ when, in a second measuring phase (102), which initiates a stopping period (100) after the first measuring phase (92), a further number of HF2 signals (48) has been measured, the time interval of which between two respective successive HF2 signals is between the fourth termination timespan (96) and the third termination timespan (94), when the further number of HF2 signals (48) is equal to a second serial number (104), and
∘ when, within the serial time period (90), a number of HF1 signals (34) has been measured, which is a number equal to a third serial number (119), wherein the time interval between two successive NF1 signals (34) is between a fifth termination timespan (106) and a sixth termination timespan (108), and when, after the last of the NF1 signals (34) for at least one timespan, which corresponds to the fifth termination timespan (106), no further NF1 signal (34) has been measured, and
- in which method the serial time period (90) is ended if, in one of the measuring phases (92, 102), the time interval of two directly successive HF2 signals (48) is greater than the third termination timespan (94).

2. Method according to claim 1, in which the serial time period (90) is ended if this had already begun, and the serial time period (90) for a first SPG timespan is not started when either, for a second SPG time period (140), the voltage (24) is not greater than an SPG voltage (134), or the lengths of two successive high timespans (136) differ by more than a third SPG timespan, wherein the high timespan (136) is the timespan within which the voltage (24) is greater than the SPG voltage (134).

3. Method according to claim 1 or 2, in which the serial time period (90) is ended, if this had already begun, and the serial time period (90) for a parallel time period (116) is not started if an NF2 signal (40) is measured that lasts longer than an NF2 threshold length (114),
- wherein an emerging interference signal (28) that has a frequency below an NF2 frequency (36) and a current intensity of the electric current of the circuit above an NF2 threshold value (38), is labelled as an NF2 signal (40), and
- wherein the parallel time period (116) is ended when
∘ a measured NF2 signal (40) lasts for a shorter amount of time than the NF2 threshold length (114), or
∘ the voltage (24) for a first termination timespan was smaller than that of a termination voltage, or
∘ for a second termination timespan (118), no NF2 signal (40) was measured, and
- wherein the arcing fault (16) is identified or reported,
∘ when, within the parallel time period (116) between all successive HF2 signals (48), the time interval is greater than or equal to a first arcing fault timespan (120),
∘ when, within the parallel time period (116) between two directly successive HF2 signals (48), the time interval is greater than or equal to a second arcing fault timespan (122), and
∘ when either a number of HF2 signals (48) was measured that is greater than or equal to a first arcing fault number (126), if, within a third arcing fault timespan (124), a number of NF2 signals (40) was measured that is between a second arcing fault number (128) and a third arcing fault number (130), or when a number of HF2 signals (48) was measured that is greater than or equal to a fourth arcing fault number (132), if, within the third arcing fault timespan (124), a number of NF2 signals (40) was measured that is greater than the third arcing fault number (130), wherein, in each case, the third arcing fault timespan (130) begins with the parallel time period (116).

4. Circuit breaker (14) that is provided and installed to carry out the method according to one of claims 1 to 3.

5. Circuit breaker (14) according to claim 4,
**characterised by**
an interrupting unit (17) for interrupting a circuit (2) as soon as the faulting arc (16) is identified or reported.

## Revendications

1. Procédé (88) de reconnaissance d'arcs parasites (16) à l'intérieur d'un circuit électrique (2) présentant une fréquence de réseau (26), un courant électrique (22) et une tension électrique (24),
- dans lequel un signal parasite (28) se produisant, qui présente une fréquence inférieure à une fréquence NF1 (30) et une intensité de courant du courant électrique du circuit électrique supérieure à un seuil limite NF1 (32), définit un signal NF1 (34),
- dans lequel une pluralité de signaux parasites (28) se produisant, qui présentent une fréquence inférieure à une fréquence HF2 (42), sont regroupés en un signal HF2 (48) lorsque la pluralité des signaux parasites (28) est supérieure ou égale à une pluralité de HF2 (50), et si l'écart temporel entre deux signaux parasites (28) consécutifs est inférieur à un temps HF2 (46),
- dans lequel un signal HF2 (48) démarre une période série (90), et
- dans lequel l'arc parasite (16) est reconnu et/ou signalé,
∘ lorsque, dans une première phase de mesure (92) de la période série (90) sont mesurés une pluralité de signaux HF2 (48) dont l'écart temporel entre deux signaux HF2 (48) consécutifs respectifs est compris entre une quatrième période de temps d'interruption (96) et une troisième période de temps d'interruption (94) lorsque la pluralité de signaux HF2 (48) est égale à une première pluralité série (98),
∘ lorsque, dans une seconde phase de mesure (102), qui commence une période d'arrêt (100) après la première phase de mesure (92), une autre pluralité de signaux HF2 (48) est mesurée dont l'écart temporel entre deux signaux HF2 consécutifs respectifs est compris entre la quatrième période de temps d'interruption (96) et la troisième période de temps d'interruption (94) lorsque l'autre pluralité de signaux HF2 (48) est égale à une seconde pluralité série (104), et
∘ lorsque, à l'intérieur de la période série (90), une pluralité de signaux NF1 (34) a été mesurée, laquelle pluralité est égale à une troisième pluralité série (119), dans lequel l'écart temporel entre deux signaux NF1 (34) consécutifs se situe entre une cinquième période de temps d'interruption (106) et une sixième période de temps d'interruption (108), et lorsque, après le dernier des signaux NF1 (34) pour au moins une période de temps, qui correspond à la cinquième période de temps d'interruption (106), aucun autre signal NF1 (34) n'a été mesuré, et
- dans lequel la période série (90) est terminée si, dans une des phases de mesure (92, 102), l'écart temporel entre deux signaux HF2 (48) directement consécutifs est supérieur à la troisième période de temps d'interruption (94).

2. Procédé selon la revendication 1, dans lequel la période série (90) est terminée si celle-ci a déjà commencé, et la période série (90) n'est pas démarrée pour une première période de temps SPG lorsque soit, pour une seconde période de temps SPG (140), la tension (24) n'est pas supérieure à une tension SPG (134), soit les longueurs de deux périodes de temps élevées (136) consécutives se différencient de plus d'une troisième période de temps SPG, dans lequel les périodes de temps élevées (136) sont la période de temps à l'intérieur de laquelle la tension (24) est supérieure à la tension SPG (134).

3. Procédé selon la revendication 1 ou 2, dans lequel la période série (90) est terminée si celle-ci a déjà commencé, et la période série (90) n'est pas démarrée pour une période parallèle (116) si est mesuré un signal NF2 (40) qui dure plus longtemps qu'une longueur limite NF2 (114),
- dans lequel un signal parasite (28) se produisant, qui présente une fréquence inférieure à une fréquence NF2 (36) et une intensité de courant du courant électrique du circuit électrique supérieure à un seuil limite NF2 (38), est désigné comme signal NF2 (40), et
- dans lequel la période parallèle (116) est terminée, lorsque
∘ un signal NF2 (40) mesuré est plus court que la longueur limite NF2 (114), ou
∘ la tension (24) pour une première période de temps d'interruption était inférieure à une tension d'interruption, ou
∘ aucun signal NF2 (40) n'a été mesuré pour une seconde période de temps d'interruption (118), et
- dans lequel l'arc parasite (16) est reconnu ou signalé,
∘ lorsque, à l'intérieur de la période parallèle (116) entre tous les signaux HF2 (48) consécutifs, l'écart temporel est supérieur ou égal à une première période de temps d'arc parasite (120),
∘ lorsque, à l'intérieur de la période parallèle (116) entre deux signaux HF2 (48) directement consécutifs, l'écart temporel est supérieur ou égal à une seconde période de temps d'arc parasite (122), et
∘ lorsque, soit une pluralité de signaux HF2 (48) a été mesurée qui est supérieure ou égale à une première pluralité d'arcs parasites (126) si, à l'intérieur d'une troisième période de temps d'arc parasite (124), une pluralité de signaux NF2 (40) a été mesurée qui se situe entre une deuxième pluralité d'arcs parasites (128) et une troisième pluralité d'arcs parasites (130), soit lorsqu'une pluralité de signaux HF2 (48) a été mesurée qui est supérieure ou égale à une quatrième pluralité d'arcs parasites (132) si, à l'intérieur de la troisième période de temps d'arc parasite (124), une pluralité de signaux NF2 (40) a été mesurée qui est supérieure à la troisième pluralité d'arcs parasites (130), dans lequel la troisième période temporelle d'arc parasite (130) respective commence avec la période parallèle (116).

4. Disjoncteur (14), qui est prévu et configuré pour exécuter le procédé selon l'une des revendications 1 à 3.

5. Disjoncteur (14) selon la revendication 4,
**caractérisé par**
une unité d'interruption (17) pour interrompre un circuit électrique (2) dès lors que l'arc parasite (16) est reconnu ou signalé.
